# EUROPEAN PATENT APPLICATION

(11) **EP 3 270 261 A1**
(43) Date of publication of application: **17.01.2018**
(21) Application number: 17178159.4
(22) Date of filing: 21.05.2009
(51) Int. Cl.: G06F 1/20, G06F 1/16, H05K 7/20, H05K 7/14, F28D 15/02, F28D 15/00, F28F 3/12, H01L 23/42, H01L 23/46

(54) **GRAPHICS CARD THERMAL INTERPOSER**

(30) Priority: 21.05.2008 US 54992
(62) Divisional of application: 09751558.9
(71) Applicant: Asetek A/S, 9220 Aalborg Ost (DK)
(72) Inventor: ALYASER, Monem, H., San Jose, CA 95125 (US); RICE, Jeremy, A., San Jose, CA 95126 (US)
(74) Representative: Chas. Hude A/S

(57) **Abstract**

A thermal interposer component (200) for a liquid cooling system configured for use with an electronic component (10) such as personal computer adapter card, and in particular, for a graphics display card. The thermal interposer component (200) consists of a planar body (202, 204) of a thermally conductive material, configured for attachment to the electronic component (10), in thermal contact on one face (206) with multiple heat sources on the electronic component (10), including at least one processor. A plurality of heat pipes (208) are seated within recessed channels (210) within the planar body (202, 204) to facilitate a transfer of thermal energy absorbed by the planar body (202, 204) from the heat sources. A modular cold plate assembly (100) coupled to a liquid cooling system is removably coupled to the planar body (202, 204) in a thermal transfer region or socket (212) opposite from the multiple heat sources, to drawn heat from the planar body, the heat pipes, and from the at least one processor via a circulating liquid coolant.

## Description

### CROSS-REFERENCE TO RELATED APPLICATIONS

The present application is related to, and claims priority from, U.S. Provisional Patent Application Serial No. 61/054,992 filed on May 21, 2008, and which is herein incorporated by reference.

### STATEMENT REGARDING FEDERALLY SPONSORED RESEARCH

Not Applicable.

### BACKGROUND OF THE INVENTION

The present invention is related generally to a system for cooling component circuit boards, electronic components, and heat sources associated with electronic components, and is directed specifically to a cooling system component adapted for use in conjunction with a liquid cooling system for cooling integrated circuit components such as those found on graphics cards in a personal computer system.

Personal computer systems which are designed for desktop or under-desk use, and which are typically characterized by a main-board or motherboard housed in a chassis or case. Auxiliary components additionally contained within the chassis or case may include network adapter circuit boards, modems, specialized adapters, and graphics display adapters. These auxiliary components may receive power through the connection to the motherboard, or through additional connections directly to a system power supply contained within the chassis or case. Additional components which generate heat, such as hard drives, disk drives, media readers, etc. may further be contained within the chassis or case, and coupled to the system power supply and motherboard as needed.

During operation, the motherboard and various auxiliary components consume power and generate heat. To ensure proper functionality of the computer system, it is necessary to regulate the operating temperatures inside the environment of the chassis or case. Individual integrated circuits, especially memory modules and processors, may generate significant amounts of heat during operation, resulting in localized hot spots within the chassis environment. The term "processors", as used herein, and as understood by one of ordinary skill in the art, describes a wide range of components, which may include dedicated graphics processing units, microprocessors, microcontrollers, digital signal processors, and general system processors such as those manufactured and sold by Intel and AMD. In an air-cooled system, the generated heat is absorbed by the ambient air within the chassis, which is then circulated or exchanged by various cooling fans. Failure to maintain adequate temperature control throughout the chassis environment, and at individual integrated circuits, can significantly degrade the system performance and may eventually lead to component failure.

Traditionally, a cooling fan is often associated with the system power supply, to circulate air throughout the chassis environment, and to exchange the high temperature internal air with cooler external air. However, as personal computer systems include increasing numbers of individual components and integrated circuits, and applications become more demanding on additional processing components such as graphics display adapters, a system power supply cooling fan may be inadequate to maintain the necessary operating temperatures within the chassis environment.

Specialized liquid cooling systems are available for some components in a personal computer system. Specialized liquid cooling systems typically required a coolant circulation pathway, which routes a thermal transfer liquid between a heat exchanger such as a radiator and a heat source, such as a CPU, GPU, microprocessor or transformer. Specialized liquid cooling systems are well adapted for maintaining adequate operating temperatures for individual components. However, these specialized liquid cooling systems are not easily adapted for use with a wide variety of components or adapter boards in a personal computer system. Furthermore, once such liquid cooling systems are installed, it is difficult to replace, insert, or remove components requiring cooling from the system, as the liquid cooling system must either be drained or breached to facilitate the replacement, insertion, or removal.

Some specialized liquid cooling systems adapted for use with plug-in adapter cards such as graphic cards utilize a cold plate component through which a cooling liquid circulates for cooling the main processor on the adapter card, and thermal radiators for air cooling the other circuit components on the adapter card. These systems often add significant space requirements to the adapter card, necessitating the use of two adapter "slots" or bays. Additionally, by continuing to utilize thermal radiators for air cooling, these systems contribute heat to the internal environment within the computer chassis, increasing the strain on other cooling components.

Personal computers are not the only electronic devices which generate heat during use. Many electronic devices contained within a chassis or case generate heat during use which must be dissipated. For example, multiple circuitboards, DC/DC converters, hard drives, optical components, rack-mounted servers, blade servers, networking switches and routers, network storage devices, military and medical electronic equipment, as well as instrumentation and testing electronics all generate heat during use which must be dissipated to avoid damage to the system.

Accordingly, it would be advantageous to provide a component for use with a liquid cooling system which may be easily adapted to provide a liquid cooling mechanism for a wide range of heat generating integrated circuit components, such as a personal computer adapter card, to cool both the adapter card processors as well as associated integrated circuits. It would be further advantageous to provide a component for a liquid cooling system which may be easily detached from an associated heat source without draining of any liquid coolant or breaching of the coolant flow pathways, enabling replacement, addition, or removal of heat source components such as upgraded processors, and which does not significantly increase the space requirements for the adapter card.

### BRIEF SUMMARY OF THE INVENTION

Briefly stated, the present disclosure provides a thermal interposer component for a liquid cooling system configured for use with a personal computer adapter card, and in particular, for a graphics display card. The interposer component consists of a planar body of a thermally conductive material, configured for attachment to the personal computer adapter card, in thermal contact on one face with one or more heat sources on the adapter card, such as a processor component. A plurality of heat pipes are embedded within the planar body to facilitate a transfer of thermal energy absorbed by the planar body from the heat sources. A cold plate component coupled to a liquid cooling system is operatively coupled to the planar body on a face opposite from the multiple heat sources to drawn heat from the planar body, the heat pipes, and from the at least one processor via a circulating liquid coolant.

In one embodiment, the planar body of the thermal interposer component is composed of an aluminum die cast plate. The dimensions of the thermal interposer component are selected based upon the computer adapter card to which the thermal interposer component is coupled, and are further selected to enable the combined assembly of the computer adapter card, thermal interposer component, and an operatively coupled cold plate component to fit within the spatial requirements of a single-slot personal computer adapter card.

The foregoing features, and advantages set forth in the present disclosure as well as presently preferred embodiments will become more apparent from the reading of the following description in connection with the accompanying drawings.

### BRIEF DESCRIPTION OF THE SEVERAL VIEWS OF THE DRAWINGS

In the accompanying drawings which form part of the specification:
Figure 1 is an exploded view of a cold plate component of the present disclosure having a base portion, a central coolant circulation portion, and a top portion;
Figure 2a-2c illustrate the top portion, bottom portion, and medially disposed heat pipes of an adapter card thermal interposer of the present disclosure in an exploded view;
Figure 3 is an exploded view of an adapter card assembly incorporating the thermal interposer of Figs. 2a-2c and the cold plate component of Fig. 1; and
Figure 4 is an exploded view of an adapter card assembly incorporating an alternate embodiment thermal interposer and cold plate component of the present disclosure.

Corresponding reference numerals indicate corresponding parts throughout the several figures of the drawings. It is to be understood that the drawings are for illustrating the concepts set forth in the present disclosure and are not to scale.
Before any embodiments of the invention are explained in detail, it is to be understood that the invention is not limited in its application to the details of construction and the arrangement of components set forth in the following description or illustrated in the drawings.

### DETAILED DESCRIPTION

The following detailed description illustrates the invention by way of example and not by way of limitation. The description enables one skilled in the art to make and use the present disclosure, and describes several embodiments, adaptations, variations, alternatives, and uses of the present disclosure, including what is presently believed to be the best mode of carrying out the present disclosure.

Personal computers, network servers, and many other variations of computing devices employ electronic sub-components such as circuit boards, adapter cards, daughter cards, DC/DC converters, hard drives, and optical drives mounted in an enclosed case or chassis. These various electronic sub-components, including a common power supply, generate heat during operation which must be dissipated from the chassis or case to avoid heat-induced damage or overheating of the various components. Common methods for extracting heat from the internal volume of a computer case or chassis include providing cooling fans for circulating airflow, and the use of liquid cooling systems to circulate a liquid coolant between the various sources of heat and a liquid-to-air radiator for discharge outside of the chassis. Typically, to utilize a circulating liquid coolant within a computing device case or chassis, individual components much be customized or configured with coolant flow pathways for connecting to the liquid coolant circulation system. Installation, removal, or replacement of components is difficult due to the need to breach the liquid coolant circulation system when altering the component configurations, resulting in the loss of liquid coolant and/or the introduction of air into the liquid coolant circulation system, which can reduce the thermal efficiency of the system.

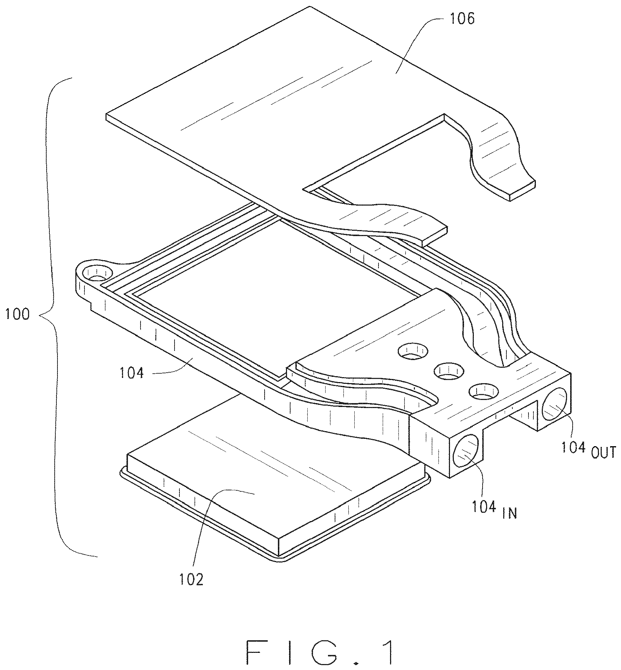

Turning to Figure 1, a modular cold-plate assembly of the present disclosure for use with a thermal interposer component is shown generally at 100. The modular cold-plate assembly provides a standardized heat transfer component for a liquid cooling system such as may be used within a chassis or case of a computer system. As seen at Fig. 1, the modular cold-plate assembly 100 consists of a cold plate body 102, configured for placement in thermal proximity to a heat source (not shown), a fluid circulation body 104, configured to circulate a flow of liquid coolant around the cold plate body 102, and a cover plate 106 configured to enclose the cold plate body 102 within the fluid circulation body 104.The external dimensions of the modular cold-plate assembly 100 are preferably standardized to facilitate reuse and interchange of the modular cold-plate assembly 100 with different thermal interposer components as required from time to time.

The cold plate body 102 is a sealed component made from materials which have a high conductivity to facilitate a transfer of heat, such as metals like copper or aluminum. Exemplary cold plate components are shown and described in co-pending International Application No. PCT/US08/56167 and in co-pending U.S. Patent Application Serial No. 12/053,202, each of which is herein incorporated by reference. The cold plate body 102 is adapted for placement in contact with the surface of the heat source (not shown), and preferably consists of a high conductivity material which is adapted for contact with the heat source. Heat is transferred from the heat source through the region of high conductivity material 102, such as copper, to the liquid coolant circulating within the volume of the fluid circulation body 104 between the cold plate body 102 and the cover plate 106. Essentially, liquid coolant enters the volume of the fluid circulation body 104 through a coolant inlet port 104_{IN}, circulates around the exposed peripheral surfaces of the cold plate body 102, and exits the fluid circulation body 104 via a coolant outlet port 104_{OUT}. The inlet and outlet ports 104_{IN} and 104_{OUT} are connected, via suitable couplings and tubing, to a liquid cooling circulation system associated with the chassis or case. Those of ordinary skill in the art will recognize that the general function of a liquid cooling system is well know for transferring thermal energy from heat sources, and as such, the components thereof will not be described in detail.

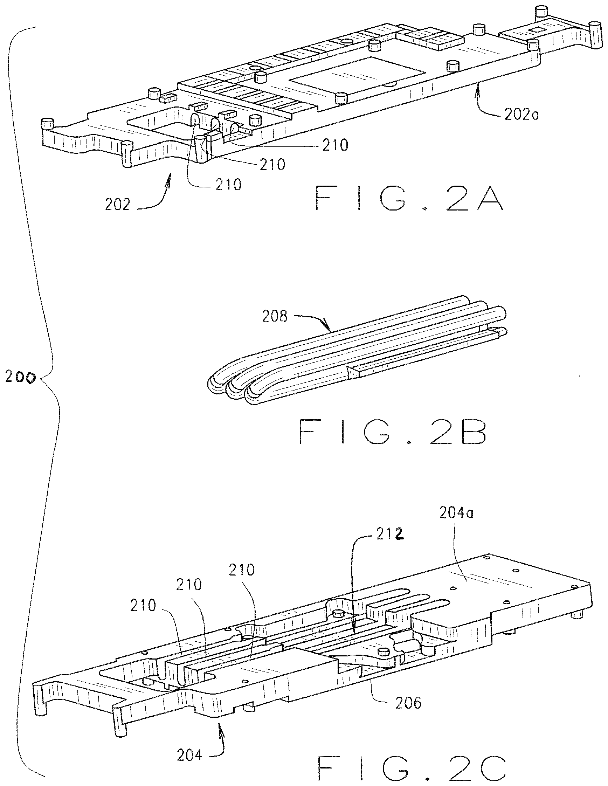

In general, the external dimensions of the modular cold plate assembly 100 are standardized to fit within a corresponding receiving space or socket within a thermal interposer assembly 200 of the present disclosure. Turning to Figures 2A-2C, an embodiment of a thermal interposer assembly 200 adapted for use with a personal computer adapter card, such as a graphics display adapter card, having multiple integrated circuits which generate heat during operation is shown generally. These integrated circuits may include, but are not limited to, voltage regulators, switches, memory components, ASICs, LEDs, DSPs, and processing components, such as general purpose processors or dedicated graphics processing units. The thermal interposer assembly 200 consists of an upper planar segment 202 and a lower planar segment 204 which seat together along mating faces 202a and 204a to form a generally planar body. The upper and lower planar segments 202 and 204 are generally unitary components, formed from a thermally conductive material, such as die-cast aluminum or graphite, and are configured for attachment to a personal computer adapter card. The lower planar segment 204 of the planar body is disposed with one side 206 generally in thermal contact with multiple heat sources on the adapter card, including at least one processor. To ensure adequate thermal contact, thermal grease or thermal gap pads may be utilized between the heat sources and the face 206 of the lower planar segment 204.

Preferably, one or more heat pipes 208 are seated within recesses 210 in the mating faces 202a, 204a, and are configured to facilitate a transfer and distribution of the thermal energy absorbed by the planar body away from the heat sources and towards a thermal discharge region 212 of the planar body which forms the receiving space or socket for the modular cold plate assembly 100. Those of ordinary skill in the art will recognize that the specific configuration of the heat pipes 208 within the planar body may be varied, depending upon the particular thermal transfer needs of each application. For example, as shown in Figure 2b, the heat pipes may be disposed in a generally parallel configuration, terminating in, or passing through the thermal discharge region 210 of the planar body.

The thermal discharge region 210, which is preferably disposed in proximity to the heat source having the greatest thermal output, such as a CPU or GPU, is a recessed region in the mating face 202a, enclosed by the mating face 204a to define a receiving slot or socket which is configured to receive the modular cold plate assembly 100. As described above, the cold plate assembly 100 is coupled to a liquid coolant circulation system via inlet and outlet portions 104_{IN} and 104_{OUT}. As the liquid coolant circulates through the cold plate assembly 100, thermal energy is drawn from each planar body, the one or more heat pipes 208, and from the various heat sources, including the processor, and is transported via the liquid coolant flow for discharge remotely from the thermal interposer assembly 200 and associated heat sources.

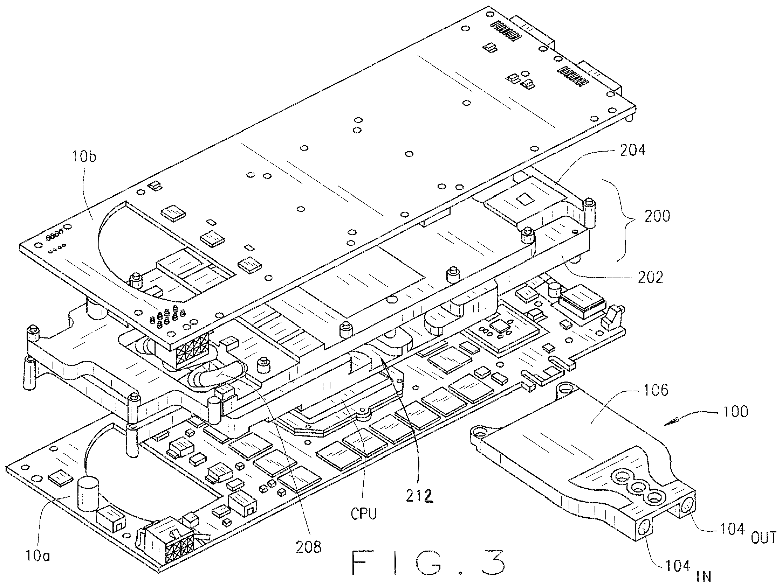

Generally, as shown in Figure 3, the dimensions of the thermal interposer component planar body are selected based upon the configuration of the computer adapter card 10a, 10b to which the thermal interposer component 200 is to be coupled, and are further selected to enable the combined assembly of the computer adapter card 10a, 10b, the thermal interposer component 200, and the operatively coupled cold plate assembly 100 to fit within the spatial requirements of either a single-slot or double-slot personal computer adapter card. Those of ordinary skill in the art will recognize that the thermal interposer component 200 may have any of a variety of different configurations based upon the particular physical space limitations associated with the electronic components being cooled, and upon the arrangement of heat sources in thermal proximity to the surfaces of the thermal interposer.

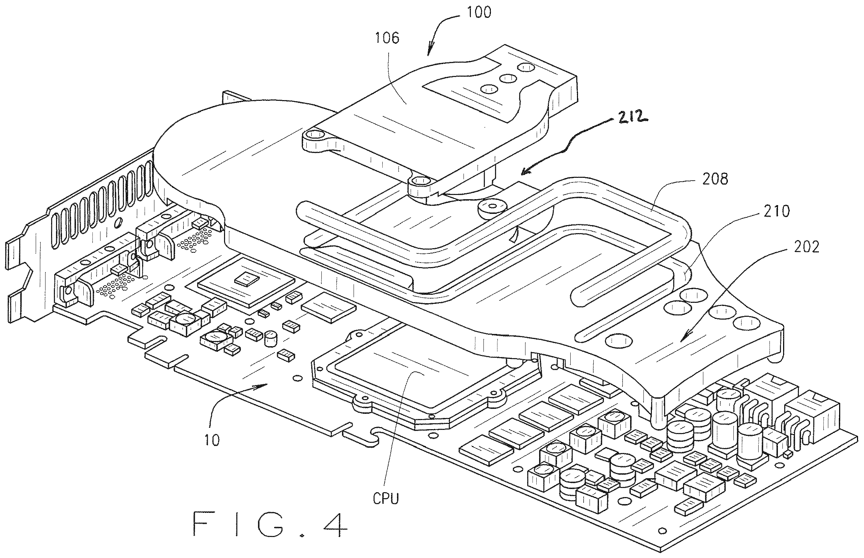

For example, while the embodiment shown in Figure 3 illustrates a thermal interposer 200 of the present disclosure having a pair of planar bodies 202 and 204 disposed in a sandwiched configuration between a pair of circuit boards 10a and 10b, the embodiment shown in Figure 4 illustrates an alternate configuration of the thermal interposer having only a single planar body 202 disposed adjacent a single circuit board 10, sized to fit within a double-slot PC card configuration.

The embodiment shown in Figure 4 illustrates an optional arrangement wherein only a single lower planar body 202 is utilized adjacent a single circuit board 10 and associated heat sources, without an upper planar body 204. The heat pipe 208 is routed through a serpentine path to facilitate transfer of thermal energy from the lower planar body 202 to the thermal transfer region 210, defined by a recessed seat or socket for receiving a modular cold plate assembly 100, and the associated cold plate assembly 100.

The use of the thermal interposer assembly 200 of the present disclosure provides several advantages for the cooling and temperature management of personal computer adapter cards, circuit boards, or other electronic components. By removably coupling the modular cold plate assembly 100 to a planar body 202 which, in turn, is in thermal contact with the various heat sources on an adapter card 10 or circuit board, the design of the liquid cooling system (not shown) may be standardized and simplified through the use of the common modular cold plate assembly 100 configuration, requiring only one or more of the thermal interposer planar bodies 202 and 204 to be modified to fit different adapter cards 10, circuit boards, or other electronic components. This in turn, reduces development and production cycles, as well as production costs. Exchange, replacement, or addition of adapter cards 10, circuit boards, or other electronic components in need of cooling to a system does not require breech of the liquid coolant circulation pathways, as the modular cold plate assembly 100 provides a standardized component which may be disconnected from a thermal interposer assembly 200 and re-installed in a replacement component without removal from the liquid coolant system or breach of the liquid coolant pathways, thereby reducing the risk of coolant loss, leaks, or the introduction of air into the system. For example, a personal computer may be provided with a liquid coolant circulation system in which a number of modular cold plate assemblies 100 are coupled to the liquid coolant circulation pathways, and which may be seated or socketed, as needed, in the thermal transfer regions or slots 210 on the thermal interposer assemblies 200 associated with adapter cards 10 or other internal peripheral components installed from time to time in the chassis or case of the personal computer.

With a planar body 202 or 204 of thermal interposer 200 in thermal contact with a plurality of heat sources, efficient cooling of multiple circuits on the adapter card 10 or circuit board is achieved with a common cooling system, eliminating the need for separate or individual cooling systems associated with each adapter card or circuit board. Heat drawn from the heat sources is retained within the planar bodies 202, 204 of the thermal interposer assembly 200 for transfer to the liquid coolant circulating through the modular cold plate assembly 100, reducing heat transfers to the ambient air surrounding the adapter card and contained within the computer chassis. Similarly, by transferring heat to the liquid coolant, the need for air circulating fans in proximity to the adapter card or circuit board is eliminated, and the overall card assembly, including the thermal interposer 200 and cold plate component 100 may be configured to fit within a selected spatial volume corresponding to a single-slot adapter card or a double-slot adapter card.

As various changes could be made in the above constructions without departing from the scope of the disclosure, it is intended that all matter contained in the above description or shown in the accompanying drawings shall be interpreted as illustrative and not in a limiting sense. For example, while the present disclosure illustrates the use of die-cast aluminum to form the planar body of the thermal interposer, those of ordinary skill in the art will recognize that any suitable thermally conductive material may be utilized, formed by any suitable forming techniques. Similarly, the specific planar configuration of the planar body shown in the drawings will be understood to be exemplary, and may be modified as required to suit any of a variety of personal computer adapter card configurations without departing from the scope of the invention.

### EMBODIMENTS

1. A thermal interposer component for thermally coupling a liquid cooling system to an electronic component having at least one heat source, comprising:
   a planar body of a thermally conductive material, configured for attachment to the electronic component, in thermal contact on one face with at least one heat source on the electronic component;
   at least one heat pipe recessed within the planar body to facilitate a transfer an distribution of thermal energy absorbed by the planar body from said heat source; and
   a modular cold plate assembly removably coupled to a receiving socket in the planar body, said receiving socket defining a thermal discharge region on a face of said planar body opposite from said at least one heat source, said modular cold plate assembly operatively coupled to a liquid cooling system to transfer thermal energy from the planar body to a coolant circulating within the liquid cooling system.
2. The thermal interposer component of item 1 wherein said planar body is composed of aluminum.
3. The thermal interposer component of item 1 wherein said planar body is composed of graphite.
4. The thermal interposer component of item 1 wherein said at least one heat pipe is disposed to transport thermal energy through said planar body towards said cold plate component disposed in said thermal discharge region.
5. The thermal interposer component of item 1 wherein said at least one heat source is a processor disposed on said electronic component, and wherein said thermal discharge region and said modular cold plate assembly are disposed diametrically opposite on said planar body from said at least one processor.
6. The thermal interposer component of item 1 wherein said thermal discharge region and said associated modular cold plate assembly are disposed on said planar body diametrically opposite from a heat source on said electronic component having the greatest thermal output.
7. The thermal interposer component of item 1 wherein said electronic component is a personal computer adapter card, and wherein said planar body and said modular cold plate assembly, when operatively assembled and coupled to said personal computer adapter card, fit within a selected spatial volume allotted for a personal computer adapter card within a personal computer chassis.
8. The thermal interposer component of item 7 wherein said selected spatial volume is defined by a standard single-slot personal computer adapter card configuration.
9. The thermal interposer component of embodiment 7 wherein said selected spatial volume is defined by a standard double-slot personal computer adapter card configuration.
10. The thermal interposer component of item 1 including a plurality of heat pipes recessed within the planar body to facilitate said distribution and transfer of thermal energy absorbed by the planar body to said modular cold plate component.
11. The thermal interposer component of item 10 wherein said plurality of heat pipes are symmetrically disposed within the planar body.
12. The thermal interposer component of item 1 wherein a layer of thermal grease is disposed to facilitate a transfer of thermal energy from said planar body to said modular cold plate component.
13. The thermal interposer component of item 1 further include one or more thermal gap pads disposed between said at least one heat source and said planar body to facilitate a transfer of thermal energy to said planar body.
14. The thermal interposer component of item 1 wherein said planar body consists of a lower planar body adapted for placement with a first planar surface in thermal adjacency to said at least one heat source of said electronic component; and an upper planar body having a planar mating surface adapted to seat against a corresponding planar mating surface of said lower planar body, and further adapted for placement with a second planar surface in thermal adjacency to a second heat source of said electronic component; and
   wherein said upper planar body and said lower planar body cooperatively define at least one passage for receiving said heat pipe, and said thermal discharge region for receiving said modular cold plate assembly there between.
15. A method for coupling an electronic component having at least one heat source in thermal contact with a thermal interposer component to a liquid cooling system having at least one modular cold plate assembly, for transferring heat from the heat source away from the electronic component, comprising:
   operatively coupling the at least one modular cold plate assembly to said thermal interposer component at a thermal transfer region, said at least one modular cold plate assembly having a circulating flow of liquid coolant from said liquid cooling system adapted to draw thermal energy from said thermal transfer region of said thermal interposer.
16. The method of item 15 for coupling an electronic component to a liquid cooling system further including the steps of initially decoupling the modular cold plate assembly from a replaced electronic component prior to operatively coupling the modular cold plate assembly to said electronic component.
17. The method of item 15 wherein said electronic component is a personal computer adapter card.

## Claims

1. A thermal interposer component for thermally coupling a liquid cooling system to a computer adapter card, such as a graphics display card, having multiple heat sources which generate heat during operation, said thermal interposer component being configured to be in thermal contact with said multiple heat sources on said adapter card and said component being operatively coupled to a liquid cooling system to transfer thermal energy from said component to a coolant circulating within the liquid cooling system.

2. A thermal interposer component according to claim 1, wherein said thermal interposer component comprises a planar body of a thermally conductive material configured for attachment to the computer adapter card in thermal contact with said multiple heat sources on the computer adapter card.

3. A thermal interposer component according to claims 1-2, wherein the dimensions of the thermal interposer component are selected based on the configuration of the computer adapter card to which the thermal interposer component is to be coupled.

4. A thermal interposer component according to claims 1-3, wherein the component is configured to facilitate a transfer and distribution of the thermal energy absorbed by the component away from the heat sources and towards a thermal discharge region of the component.

5. A thermal interposer component according to claim 4, wherein the thermal discharge region is preferably in proximity to the heat source having the greatest thermal output, such as a CPU or GPU.

6. A thermal interposer component according to claims 4-5, wherein said thermal discharge region is defined by a recessed receiving socket for receiving a modular cold plate.

7. A thermal interposer component according to any of the preceding claims, wherein a modular cold plate assembly is removably coupled to said receiving socket in said thermal interposer component, said receiving socket having external dimensions corresponding to external dimensions of said modular cold plate assembly.

8. A thermal interposer component according to claims 6-7, wherein the modular cold plate assembly is coupled to the liquid cooling system.
